# EUROPÄISCHE PATENTSCHRIFT

(11) **EP 2 012 576 B1**
(45) Veröffentlichungstag und Bekanntmachung des Hinweises auf die Patenterteilung: **19.11.2014**
(21) Anmeldenummer: 08104405.9
(22) Anmeldetag: 13.06.2008
(51) Int. Cl.: H05K 13/04

(54) **Bestückautomat und Verfahren zum Handhaben von Bauelementen**
Automatic filling machine and method for handling components
Automate d'implantation et procédé de manipulation de composants

(30) Priorität: 06.07.2007 DE 102007031487
(43) Veröffentlichungstag der Anmeldung: 07.01.2009
(73) Patentinhaber: ASM Assembly Systems GmbH & Co. KG, 81379 München (DE)
(72) Erfinder: Bachthaler, Thomas, 82131, Stockdorf (DE)
(74) Vertreter: Kuhlmann, Kai

(56) Entgegenhaltungen:
- EP-A2- 2 111 092
- JP-A- 6 045 787
- US-A- 4 631 816

## Beschreibung

Die Erfindung betrifft einen Bestückautomaten zum Bestücken von Substraten mit Bauelementen sowie ein Verfahren zum Handhaben von Bauelementen.

Bei einem Bestückautomaten zum Bestücken von Substraten mit elektrischen Bauteilen werden die Bauteile durch am Bestückautomaten angeordnete Zuführeinrichtungen an definierten Abholpositionen bereitgestellt. Dort werden die Bauelemente von einem Bestückkopf des Bestückautomaten abgeholt und in einen Bestückbereich transferiert, wo sie auf den Substraten positioniert werden. Leere Substrate werden über eine Transporteinrichtung dem Bestückbereich zugeführt, fertig bestückte Substrate werden über diese Transporteinrichtung wieder aus dem Bestückbereich heraustransportiert. Um die Bestückleistung der Bestückautomaten zu erhöhen werden Bestückköpfe eingesetzt, welche ein gleichzeitiges Absetzen mehrerer Bauelemente erlauben.

Aus der Offenlegungsschrift DE 10202290 A1oder US 4 631 816 A ist ein Bestückkopf bekannt, der die relative Lage mehrerer Halteeinrichtungen so einstellt, so dass mittels eines einzigen Absetzvorganges eine Mehrzahl von Bauelementen auf dem Substrat abgesetzt werden können.

Der Erfindung liegt die Aufgabe zugrunde, einen Bestückautomaten sowie ein Verfahren zum Handhaben von Bauelementen bereitzustellen, welche sich durch eine höhere Flexibilität beim gleichzeitigen Absetzen der Bauelemente auf dem Substrat auszeichnen.

Diese Aufgabe wird durch den Bestückautomaten sowie das zugehörige Handhabungsverfahren gemäß den unabhängigen Ansprüchen gelöst. Vorteilhafte Ausgestaltungen sind Gegenstand der abhängigen Ansprüche.

Der Bestückautomat zum Bestücken von Substraten mit Bauelementen gemäß Anspruch 1 verfügt über einen Bestückkopf, welcher einen Grundkörper aufweist, der um eine senkrecht zu einer Substratebene gerichtete Drehachse drehbar gelagert ist. Weiterhin verfügt der Bestückkopf über mindestens zwei Handhabungseinrichtungen, welche an dem Grundkörper angeordnet sind und jeweils Haltmittel zum Halten der Bauelemente aufweisen. Ferner verfügt der Bestückautomat über eine Positioniervorrichtung, mittels der der Bestückkopf parallel zur Substratebene verfahrbar ist, wobei mindestens eine der Handhabungseinrichtungen eine Schwenkachse aufweist, so dass durch Drehung der mindestens einen Handhabungseinrichtung um diese Schwenkachse der relative Abstand der Haltemittel variierbar ist.

Unter der Substratebene ist dabei diejenige Ebene zu verstehen, in der sich die zu bestückende Oberfläche des Substrats befindet. Mit Hilfe des Bestückautomaten kann der Abstand, der durch die Haltemittel gehaltenen Bauelemente in einen breiten Bereich variiert werden, wodurch eine hohe Flexibilität beim Handhaben und Positionieren der Bauelemente erreicht wird. Durch Überlagerung der Bewegung der Schwenkachse mit der Drehachse sowie den Portalachsen kann der Verfahrbereich der Portalachsen bei gleichen erreichbaren Positionen verringert werden, wodurch die Transferzeit deutlich reduziert werden kann. Ebenfalls verringert sich hierdurch der notwendige Bauraum. Dies führt zu einer kleineren Maschine und folglich zu einem besseren Verhältnis von Bestückleistung zu Flächenbedarf.

Bei einer Ausgestaltung des Bestückautomaten gemäß Anspruch 2 ist die mindestens eine Schwenkachse parallel zur Drehachse angeordnet.

Hieraus ergibt sich der Vorteil, dass die von den Haltemitteln der Handhabungseinrichtungen gehaltenen Bauelemente in einer gemeinsamen Ebene bewegt werden können, welche parallel zur Substratebene orientiert ist. Hierdurch wird ein gleichzeitiges Handhaben mehrerer Bauelemente ermöglicht.

In einer Ausgestaltung des Bestückautomaten gemäß Anspruch 3 weisen die mindestens zwei Handhabungseinrichtungen Einzelschwenkantriebe auf, mittels denen die jeweilige Handhabungseinrichtung um ihre jeweilige Schwenkachse drehbar ist.

Durch Verwendung von Einzelschwenkantrieben ergibt sich der Vorteil, dass die Handhabungseinrichtungen unabhängig voneinander um ihre jeweilige Schwenkachse gedreht werden können, ohne dass sie hierfür an einen zentralen Schwenkantrieb angekoppelt werden müssen. Dadurch kann sowohl die Positioniergenauigkeit erhöht als auch der Zeitanteil für das Positionieren reduziert werden.

Gemäß einer Ausgestaltung des Bestückautomaten nach Anspruch 4 weisen die mindestens zwei Handhabungseinrichtungen weitere Einzelantriebe auf, mittels denen die Haltemittel jeweils um eine z-Achse, welche parallel zur Drehachse angeordnet ist, drehbar sowie in Richtung dieser jeweiligen z-Achse verschiebbar sind.

Mit Hilfe dieser weiteren Einzelantriebe können die Haltemittel individuell in z-Richtung verschoben sowie um sich selbst gedreht werden. Dies erlaubt eine höhere Flexibilität für den Einsatz des Bestückkopfes als bei Verwendung gemeinsamer Dreh- oder z-Antriebe. Ferner können auch hier die Zeitanteile für das Positionieren reduziert werden.

In einer Ausgestaltung des Bestückautomaten gemäß Anspruch 5 ist der Grundkörper des Bestückkopfs rotationssymmetrisch zur Drehachse ausgeführt. Die Handhabungseinrichtungen sind dabei in den Randbereichen des Grundkörpers angeordnet.

Durch diese konstruktive Ausgestaltung wird ein hohes Maß an Flexibilität erreicht. Beispielsweise kann es für das Erreichen einer Bestückposition ausreichend sein, lediglich die Drehachse des Grundkörpers sowie die Schwenkachsen der Handhabungseinrichtungen zu verfahren, nicht jedoch die Portalachsen der Positioniervorrichtung, wodurch ein zusätzlicher Wärmeeintrag in das Portal vermieden werden kann. Ist jedoch aufgrund des größeren Abstands zweier Bestückpositionen eine Portalbewegung erforderlich, so können die Bewegungen der unabhängigen Achsen (Dreh- und Schwenkachsen bzw. Portalachsen) überlagert werden. Hieraus lassen sich eine höhere relative Geschwindigkeit des Bauteils und damit eine kürzere Gesamtpositionierzeit erreichen, was sich vor allem auf die Realleistung des Bestückautomaten auswirkt.

Gemäß Anspruch 6 wird ein Verfahren zum Handhaben von Bauelementen für einen Bestückautomaten nach Anspruch 1 beansprucht, wobei der Abstand der Haltemittel durch Drehung der Handhabungseinrichtungen um die jeweilige Schwenkachse derart eingestellt wird, dass mehrere Bauelemente gleichzeitig gehandhabt werden können.

Eine gleichzeitige Handhabung mehrerer Bauelemente ist beispielsweise möglich, wenn sich der Bestückkopf im Bereich der Abholposition, der Bestückposition oder der Überprüfungsposition befindet und die dort auszuführenden Prozessschritte - wie Abholen, Bestücken oder Lageerkennung - für mehrere Bauelemente gleichzeitig ausführt. Durch das Parallelisieren von Prozessschritten für mehrere Bauelemente können die jeweiligen Prozesszeiten deutlich reduziert werden, was sich unmittelbar auf die Realleistung des Bestückautomaten auswirkt.

In einer Ausgestaltung des Verfahrens gemäß Anspruch 7 werden die Bauelemente an Abholpositionen am Bestückautomaten bereitgestellt. Der Abstand der Haltemittel wird derart eingestellt, dass mehrere Bauelemente gleichzeitig von ihren Abholpositionen durch die Haltemittel aufgenommen werden können.

Durch das gleichzeitige Abholen mehrerer Bauelemente von ihren Abholpositionen kann die hierfür benötigte Prozesszeit deutlich reduziert sowie die Realleistung des Bestückautomaten entsprechend gesteigert werden.

Bei einer Ausgestaltung des Verfahrens gemäß Anspruch 8 wird jedem Bauelement eine Bestückposition auf dem Substrat eindeutig zugeordnet. Ferner wird der Abstand der Haltemittel derart eingestellt, dass mehrere von den Haltemitteln gehaltene Bauelemente gleichzeitig auf das Substrat abgesetzt werden können.

Hierdurch lassen sich auch beim Bestücken Hauptprozesszeiten parallelisieren, so dass die Gesamtprozesszeit für das Bestücken deutlich reduziert werden kann, was sich wiederum positiv auf die Realleistung des Bestückautomaten auswirkt.

Bei einer Ausgestaltung des Verfahrens gemäß Anspruch 9 wird der Bestückkopf nach dem Einstellen des Abstands der Haltemittel und vor dem Absetzen der Bauelemente auf das Substrat zu einer Überprüfungseinrichtung zur Überprüfung der Lage der aufgenommenen Bauelemente verfahren.

Hieraus ergibt sich der Vorteil, dass die Lage der gehaltenen Bauelemente exakt überprüft und ggf. korrigiert wird, bevor die Bauelemente auf das Substrat abgesetzt werden. Dadurch, dass die Achsen des Bestückkopfes bereits vor der Lageüberprüfung der aufgenommenen Bauelemente in ihre Zielpositionen verfahren werden und nach der Überprüfung der Lage nur noch geringfügige Korrekturen durchgeführt werden, lässt sich die Bestückgenauigkeit deutlich verbessern.

Gemäß dem Verfahren zum Handhaben von Bauelementen nach Anspruch 10 wird der Bestückkopf vor dem Absetzen der Bauelemente auf dem Substrat zu einer Überprüfungseinrichtung zur Überprüfung der Lage der aufgenommenen Bauelemente verfahren. Weiterhin werden vor dem Überprüfungsvorgang die Handhabungseinrichtungen derart um ihre Schwenkachsen gedreht, dass der relative Abstand der aufgenommenen Bauelemente reduziert wird.

Der relative Abstand der Bauelemente zueinander kann derart reduziert werden, dass in einer senkrechten Projektion auf die Substratebene die durch eine Hüllkurve um alle Bauelemente eingeschlossene Fläche verringert wird. Hierdurch lässt sich der für die Überprüfungsvorrichtung vorgesehene Bauraum deutlich reduzieren. Ferner sind deutlich günstigere Überprüfungsvorrichtungen einsetzbar.

Im Folgenden wird die Erfindung anhand eines Ausführungsbeispiels unter Bezug auf die beigefügten Figuren näher erläutert. Dabei zeigen
- Figur 1: eine schematische Darstellung eines Bestückautomaten,
- Figur 2: eine schematische Seitenansicht eines Bestückkopfs
- Figur 3: eine Draufsicht des Bestückkopfs über dem Abholbereich
- Figur 4: eine Draufsicht des Bestückkopfs über dem Bestückbereich

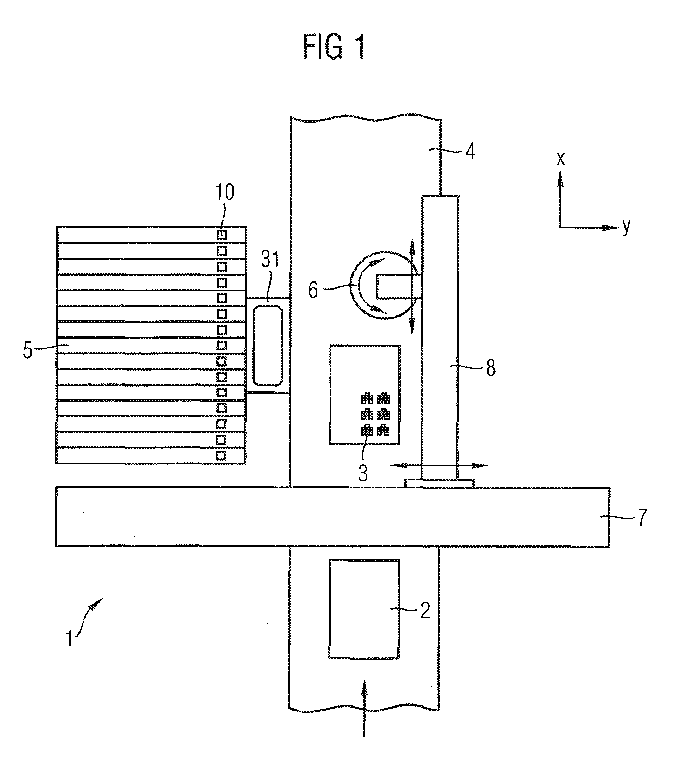

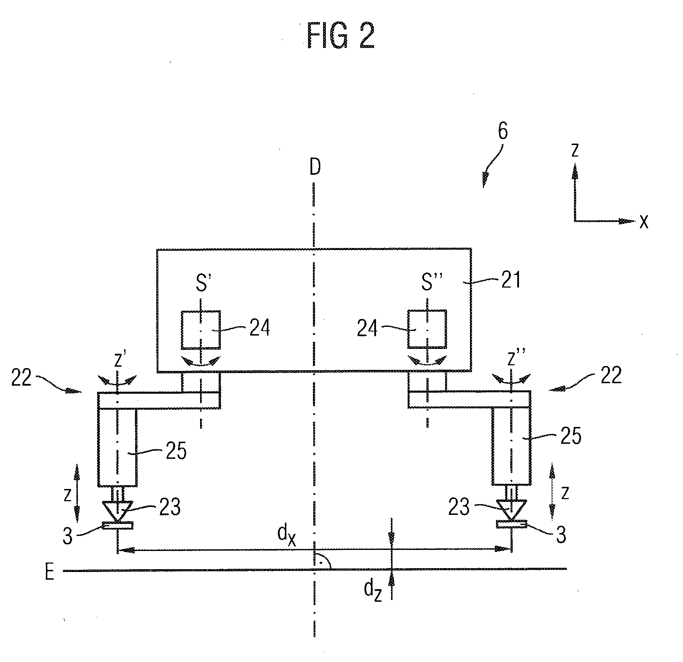

Figur 1 zeigt schematisch einen Bestückautomaten 1 zum Bestücken von Substraten 2 mit Bauelementen 3. Der Bestückautomat besteht aus einem Querträger 7, welcher sich in einer y-Richtung erstreckt und fest mit einem Maschinengestell (nicht dargestellt) verbunden ist. Am Querträger 7 ist ein Portalarm 8 angebracht, welcher sich in x-Richtung erstreckt und in y-Richtung verschiebbar am Querträger 7 befestigt ist. Querträger 7 und Portalarm 8 bilden zusammen die Positioniervorrichtung, wobei durch die x-Achse und die y-Achse ein orthogonales Bezugssystem gebildet wird. Am Portalarm 8 ist ein Bestückkopf 6 in x-Richtung verschiebbar angebracht, welche über eine Mehrzahl von Handhabungseinrichtungen 22 (siehe Figur 2) verfügt. Weiterhin ist eine Transportstrecke 4 zum Transport der Substrate 2 in einen Bestückbereich vorgesehen. Seitlich der Transportstrecke 4 sind Zuführvorrichtungen 5 in einem Abholbereich des Bestückautomaten 1 angeordnet, mittels derer die Bauelemente 3 bereitgestellt werden. Zwischen dem Abholbereich und dem Bestückbereich ist eine Überprüfungseinrichtung 31 zur Überprüfung der Lage der zu bestückenden Bauelemente 3 angeordnet.

Zum Bestücken werden die Substrate 2 über die Transportstrecke 4 in den Bestückbereich des Bestückautomaten 1 transportiert. Die von den Zuführvorrichtungen 5 im Abholbereich bereitgestellten Bauelemente 3 werden von dem Bestückkopf 6 abgeholt und in Richtung des Bestückbereichs transferiert. Auf dem Weg dorthin wird die Überprüfungseinrichtung 31 angefahren, so dass die vom Bestückkopf 6 mitgeführten Bauelemente 3 hinsichtlich ihrer Lage und Orientierung überprüft werden können. Anschließend werden die Bauelemente 3 auf dem Substrat 2 positioniert.

In Figur 2 ist ein Ausführungsbeispiel des Bestückkopfs 6 in einer Seitenansicht schematisch dargestellt. Der Bestückkopf 6 weist einen Grundkörper 21 auf, welcher um eine Drehachse D, die orthogonal zur Substratebene E ausgerichtet ist, drehbar gelagert ist. An dem Grundkörper 21 sind Handhabungseinrichtungen 22 angeordnet, welche jeweils über einen Einzelschwenkantrieb 24 verfügen, mit dessen Hilfe sie um ihre jeweilige Schwenkachse S' bzw. S" exzentrisch ausgelenkt werden können. Am freien Ende der Handhabungseinrichtungen 22 sind Haltemittel 23 zum Aufnehmen und Halten elektrischer Bauelemente 3 vorgesehen. Als Haltemittel 23 können neben Vakuum-Saugpipetten beispielsweise auch mechanische Greifer eingesetzt werden. Mit Hilfe jeweils eines weiteren Einzelantriebs 25 ist es möglich, die Haltemittel 23 sowohl in einer z-Richtung zu verschieben, als auch um ihre eigene Achse z' bzw. z" parallel zur z-Richtung zu drehen.

Sowohl die Schwenkachsen S' bzw. S" der Handhabungseinrichtungen 22 als auch die Drehachse D des Grundkörpers 21 sind dabei parallel zur z-Richtung orientiert, so dass ein gehaltenes Bauelement 3 sowohl bei Drehung um die Drehachse D als auch um die Schwenkachse S' bzw. S" oder um die eigene Drehachse z' bzw. z" des Haltemittels 23 immer in einer Ebene parallel zur Substratebene E bewegt wird. Eine Bewegung in z-Richtung ist hierdurch nicht möglich. Da auch die Positioniervorrichtung 7, 8 (siehe Figur 1) derart angeordnet ist, dass der Bestückkopf 6 in einer Ebene parallel zur Substratebene E verfahrbar ist, befinden sich die transportierten Bauelemente 3 sowohl bei den Drehbewegungen des Bestückkopfs 6 als auch bei den Verfahrbewegungen der Positioniervorrichtung 7, 8 immer im gleichen Abstand d_{z} zur Substratebene E. Die Veränderung dieses Abstands d_{z} erfolgt mit Hilfe des jedem Haltemittel 23 zugeordneten Einzelantriebs 25, welcher auch eine Verschiebung des Haltemittels in z-Richtung ermöglicht. Mit Hilfe dieser konstruktiven Ausführung ist es möglich, den relativen Abstand dₓ der Haltemittel 23 und damit der Bauelemente 3 flexibel einzustellen, ohne dabei die Höhenlage der Bauelemente 3 über der Substratebene E zu verändern.

In Figur 2 sind lediglich zwei Handhabungseinrichtungen 22 dargestellt. Es ist jedoch ebenso möglich, weitere Handhabungseinrichtungen 22 am Grundkörper 21 des Bestückkopfs 6 anzuordnen.

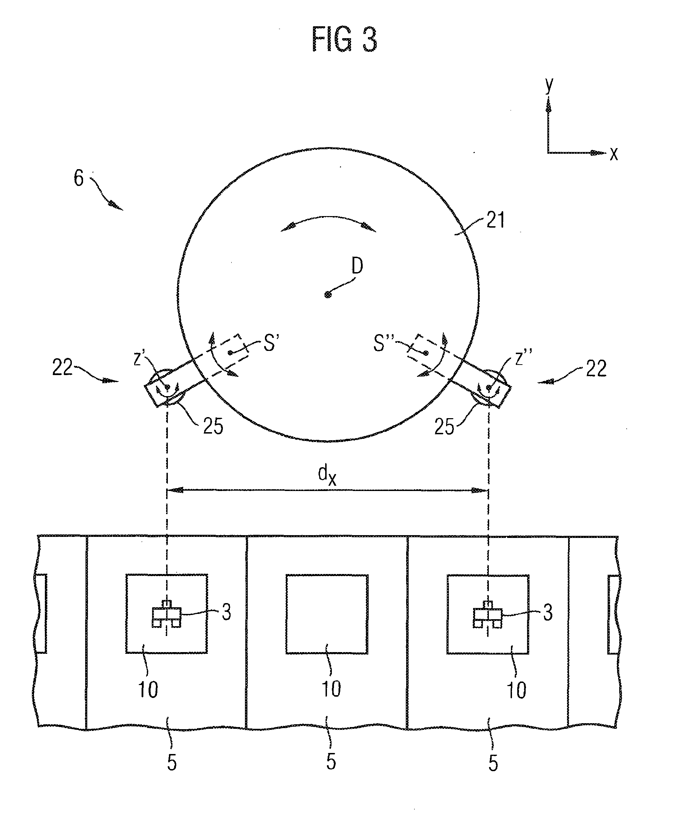

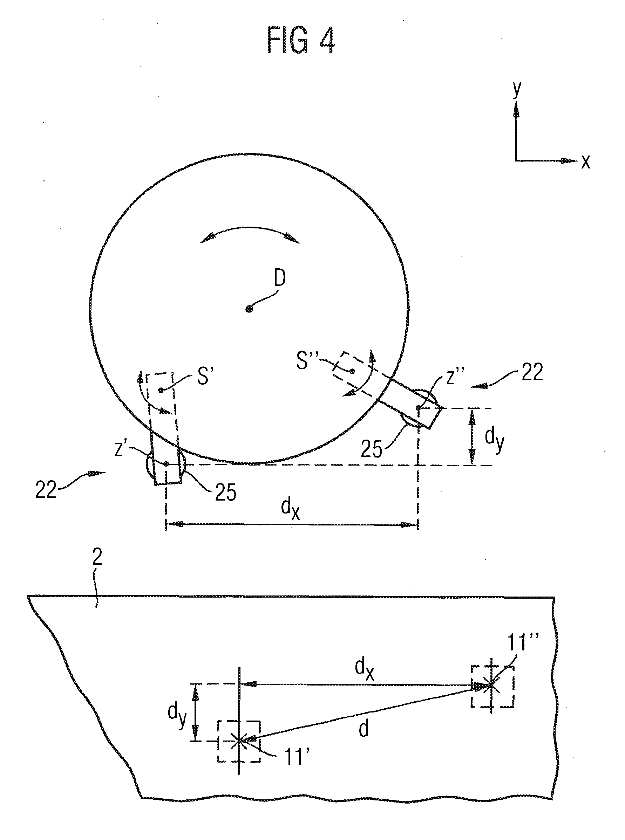

Ein Ausführungsbeispiel eines Verfahrens zum Handhaben mehrerer Bauelemente 3 unter Verwendung des oben beschriebenen Bestückautomaten 1 wird anhand der Figuren 3 und 4 erläutert.

Das Verfahren kann damit begonnen werden, dass der Bestückkopf 6 in den Abholbereich des Bestückautomaten 1 verfahren wird. Figur 3 zeigt den Bestückkopf 6 in einer Draufsicht im Abholbereich vor der Aufnahme der Bauelemente 3.

Die beiden Handhabungseinrichtungen 22 werden derart relativ zueinander positioniert, dass zwei zugeordnete Bauelemente 3 gleichzeitig aufgenommen werden können. Dies geschieht durch Drehung der Handhabungseinrichtungen 22 um ihre zugeordneten Schwenkachsen S' und S" sowie durch Drehung des Bestückkopfs 6 um die Drehachse D. Im positionierten Zustand entspricht der relative Abstand der Haltemittel 23 in x- und y-Richtung dem relativen Abstand der aufzunehmenden Bauelemente 3, die beiden Haltemittel 23 sind in x-Richtung parallel zu den Abholfenstern 10 ausgerichtet.

Anschließend wird der Bestückkopf 6 mittels der Positioniervorrichtung 7, 8 derart in x-y-Richtung verfahren, dass sich die beiden Haltemittel 23 direkt über den beiden abzuholenden Bauelementen 3 befinden.

Anschließend erfolgt mittels der beiden Einzelantriebe 25 eine gleichzeitige Zustellbewegung der beiden Haltemittel 23 in z-Richtung, die beiden Bauelemente werden zeitgleich abgeholt.

Nach dem Abholen der Bauelemente 3 wird der Bestückkopf 6 in den Bestückbereich des Bestückautomaten 1 verfahren. Figur 4 zeigt den Bestückkopf 6 im Bestückbereich vor dem Absetzen der Bauelemente 3 auf dem Substrat 2. Dabei ist jedem Bauelement 3 eine Bestückposition 11 auf dem Substrat 2 eindeutig zugeordnet.

Die beiden Handhabungseinrichtungen 22 werden derart relativ zueinander positioniert, dass die beiden von den Haltemitteln 23 gehaltenen Bauelemente 3 gleichzeitig auf dem Substrat 2 abgesetzt werden können. Dies geschieht wiederum durch Drehung der Handhabungseinrichtungen 22 um ihre zugeordneten Schwenkachsen S' und S" sowie durch Drehung des Bestückkopfs 6 um die Drehachse D. Im positionierten Zustand entspricht der relative Abstand der Haltemittel 23 dem relativen Abstand d der Bestückpositionen 11' und 11", d.h. der Abstand der Haltemittel 23 in x- und y-Richtung (dₓ bzw. d_{y}) entspricht dem Abstand dₓ bzw. d_{y} der Bestückpositionen 11' und 11" in x- und y-Richtung, so dass zum Erreichen der letztendlichen Absetzposition, von welcher aus nur noch eine Zustellbewegung in z-Richtung erfolgt, nur noch ein Verfahren des Bestückkopfs 6 in x-y-Richtung erforderlich ist.

Anschließend wird der Bestückkopf 6 mittels der Positioniervorrichtung 7, 8 derart in x-y-Richtung verfahren, dass sich die beiden Haltemittel 23 direkt über den beiden Bestückpositionen 11' und 11" befinden.

Mittels der beiden Einzelantriebe 25 erfolgt anschließend eine gleichzeitige Zustellbewegung der beiden Haltemittel 23 in z-Richtung, so dass die beiden Bauelemente 3 zeitgleich auf dem Substrat 2 abgesetzt werden können.

Sind alle Bauelemente 3 auf ihren Bestückpositionen 11 positioniert, verfährt der Bestückkopf 6 wieder in den Abholbereich, der Zyklus beginnt von neuem.

Vorteilhafterweise wird der Bestückkopf 6 nach dem Aufnehmen und vor dem Absetzen der Bauelemente 3 zu einer Überprüfungseinrichtung 31 (siehe Figur 1) zu verfahren. Diese überprüft die Lage der gehaltenen Bauelemente 3, so dass vor dem Absetzen der Bauelemente 3 noch Lage- oder Winkelkorrekturen durchgeführt werden können. Hierfür kommen zwei Möglichkeiten in Betracht:
Das Einstellen der relativen Endlage der Handhabungseinrichtungen 22 wird vor dem Überprüfungsvorgang durchgeführt. Hierdurch sind nach dem Überprüfungsvorgang nur noch geringfügige Winkelkorrekturen durch die Einzelantriebe 25 sowie das Verfahren des Bestückkopfs 6 in den Bestückbereich notwendig, wodurch die Bestückgenauigkeit verbessert wird.

Alternativ wird das Einstellen der relativen Endlage der Handhabungseinrichtungen 22 nach dem Überprüfungsvorgang durchgeführt. Hieraus eröffnet sich die Möglichkeit, zur Überprüfung die Schwenkachsen S' und S" derart zu verfahren, dass die gehaltenen Bauelemente 3 möglichst nahe und dicht beieinander angeordnet sind. Der relative Abstand der Bauelemente zueinander kann derart reduziert werden, dass in einer senkrechten Projektion auf die Substratebene die durch eine Hüllkurve um alle Bauelemente eingeschlossene Fläche verringert wird. Durch die Reduktion der zur Überprüfung der Bauelementlage notwendigen Fläche kann eine kompaktere und damit deutlich kostengünstigere Überprüfungseinrichtung 31 eingesetzt werden.

Erst nach dem Überprüfungsvorgang erfolgt die Einstellung der Handhabungseinrichtungen 22 in ihre relative Endlage, sowie die entsprechende Winkelkorrektur durch die Einzelantriebe 25.

Sowohl beim Abholen als auch beim Bestücken der Bauelemente 3 besteht die Möglichkeit, die Einstellbewegungen um die Drehachse D und die beiden Schwenkachsen S' bzw. S" sowie die x-y-Bewegung der Positioniervorrichtung 7,8, sequentiell oder parallelisiert auszuführen.

Durch das Parallelisieren der verschiedenen Rotations- und Translationsbewegungen sowie das gleichzeitige Abholen und Bestücken mehrerer Bauelemente 3 kann die Prozesszeit deutlich reduziert werden, so dass eine höhere Bestückleistung des Bestückautomaten 1 realisierbar ist.

Obwohl in den Figuren 3 und 4 nur zwei Handhabungseinrichtungen 22 dargestellt sind ist es bei Verwendung mehrerer Handhabungseinrichtungen 22 ebenso möglich, mehr als zwei Bauelemente 3 gleichzeitig abzuholen bzw. auf das Substrat 2 abzusetzen.

### Bezugszeichenliste:

- 1: Bestückautomat
- 2: Substrat
- 3: Bauelement
- 4: Transportstrecke
- 5: Bauelement-Zuführvorrichtung
- 6: Bestückkopf
- 7: Querträger
- 8: Portalarm
- 9: Bauelementgurt
- 10: Abholposition
- 11: Bestückposition

- 21: Grundkörper
- 22: Handhabungseinrichtung
- 23: Haltemittel
- 24: Einzelschwenkantrieb
- 25: Einzelantrieb

- 31: Überprüfungseinrichtung

- E: Substratebene
- D: Drehachse
- S: Schwenkachse
- d: relativer Abstand zweier Haltemittel

## Patentansprüche

1. Bestückautomat (1) zum Bestücken von Substraten (2) mit Bauelementen (3), mit:
- einem Bestückkopf (6), mit
• einem Grundkörper (21), welcher um eine senkrecht zu einer Substratebene (E) gerichteten Drehachse (D) drehbar gelagert ist,
• mindestens zwei Handhabungseinrichtungen (22), welche an dem Grundkörper (21) angeordnet sind und jeweils Haltemittel (23) zum Halten der Bauelemente (3) aufweisen,
- einer Positioniervorrichtung (7, 8), mittels der der Bestückkopf parallel zur Substratebene (E) verfahrbar ist,
wobei mindestens eine der Handhabungseinrichtungen (22) eine Schwenkachse (S) aufweist, so dass durch Drehung um diese Schwenkachse (S) der relative Abstand (d) der Haltemittel (23) beim Absetzen der Bauelemente (3) variierbar ist **dadurch gekennzeichnet, dass** der relative Abstand beim gleichzeitigen Absetzen der Bauelemente, variierbar ist.

2. Bestückautomat (1) nach Anspruch 1,
wobei die mindestens eine Schwenkachse (S) parallel zur Drehachse (D) angeordnet ist.

3. Bestückautomat (1) nach einem der Ansprüche 1 oder 2,
wobei die mindestens zwei Handhabungseinrichtungen (22) Einzelschwenkantriebe (24) aufweisen, mittels denen die jeweilige Handhabungseinrichtung (22) um ihre jeweilige Schwenkachse (S) drehbar ist.

4. Bestückautomat (1) nach einem der Ansprüche 1 bis 3,
wobei die mindestens zwei Handhabungseinrichtungen (22) weitere Einzelantriebe (25) aufweisen, mittels denen die Haltemittel (23) jeweils um eine z-Achse, parallel zur Drehachse (D), drehbar, sowie in Richtung dieser jeweiligen z-Achse verschiebbar sind.

5. Bestückautomat (1) nach einem der Ansprüche 1 bis 4,
wobei der Grundkörper (21) rotationssymmetrisch zur Drehachse (D) ausgeführt ist und die Handhabungseinrichtungen (22) in den Randbereichen des Grundkörpers (21) angeordnet sind.

6. Verfahren zum Handhaben von Bauelementen (3) für einen Bestückautomat (1) nach Anspruch 1, wobei
der Abstand (d) der Haltemittel (23) durch Drehung der Handhabungseinrichtungen (22) um die jeweilige Schwenkachse (S) derart eingestellt wird, dass mehrere Bauelemente (3) gleichzeitig gehandhabt werden können.

7. Verfahren zum Handhaben von Bauelementen (3) nach Anspruch 6, wobei
- die Bauelemente (3) an Abholpositionen (10) am Bestückautomaten (1) bereitgestellt werden,
- der Abstand (d) der Haltemittel (23) derart eingestellt wird, dass mehrere Bauelemente (3) gleichzeitig von ihren Abholpositionen (10) durch die Haltemittel (23) aufgenommen werden können.

8. Verfahren zum Handhaben von Bauelementen (3) nach einem der Ansprüche 6 und 7, wobei
- jedem Bauelement (3) eine Bestückposition (11) auf dem Substrat (2) eindeutig zugeordnet wird,
- der Abstand (d) der Haltemittel (23) derart eingestellt wird, dass mehrere von den Haltemitteln (23) gehaltene Bauelemente (3) gleichzeitig auf das Substrat (2) abgesetzt werden können.

9. Verfahren zum Handhaben von Bauelementen (3) nach Anspruch 8, wobei
nach dem Einstellen des Abstands (d) der Haltemittel (23) und vor dem Absetzen der Bauelemente (3) auf das Substrat (2) der Bestückkopf (6) zu einer Überprüfungseinrichtung (31) zur Überprüfung der Lage der aufgenommenen Bauelemente (3) verfahren wird.

10. Verfahren zum Handhaben von Bauelementen (3) nach Anspruch 8, wobei
- vor dem Absetzen der Bauelemente (3) auf das Substrat (2) der Bestückkopf (6) zu einer Überprüfungseinrichtung (31) zur Überprüfung der Lage der aufgenommenen Bauelemente (3) verfahren wird,
- vor dem Überprüfungsvorgang die Handhabungseinrichtungen (22) derart um ihre Schwenkachsen (S) gedreht werden, dass der relative Abstand (d) der aufgenommenen Bauelemente (3) reduziert wird.

## Claims

1. A placement machine (1) for placing components (3) onto substrates (2), comprising:
- a placement head (6), comprising
• a base body (21) that is rotatably mounted to a rotation axis (D) that is directed perpendicular to a substrate plane (E),
• at least two handling devices (22) which are arranged at the base body (21) and each have holding means (23) for holding the components (3),
- a positioning device (7, 8) by means of which the placement head can be moved parallel to the substrate plane (E),
wherein at least one of the of the handling devices (22) has a swivel axis (S) so that the relative distance (d) of the holding means (23) can be varied when putting down the components (3) by rotating about said swivel axis (S), **characterized in that** the relative distance can be varied when simultaneously putting down the components.

2. The placement machine (1) according to claim 1,
wherein the at least one swivel axis (S) is arranged parallel to the rotation axis (D).

3. The placement machine (1) according to claim 1 or claim 2,
wherein the at least two handling devices (22) have individual rotary drives (24) by means of which the respective handling device (22) can be rotated about its respective swivel axis (S).

4. The placement machine (1) according to any one of the claims 1 to 3,
wherein the at least two handling devices (22) have further individual drives (25) by means of which the holding means (23) can be rotated in each case about a z-axis, parallel to the rotation axis (D), and can be moved in the direction of this respective z-axis.

5. The placement machine (1) according to any one of the claims 1 to 4,
wherein the base body (21) is configured to be rotationally symmetric to the rotation axis (D), and the handling devices (22) are arranged in the edge region of the base body (21).

6. A method for handling components (3) for a placement machine (1) according to claim 1, wherein
the distance (d) of the holding means (23) is adjusted by rotating the handling devices (22) about the respective swivel axis (S) in such a manner that a plurality of components (3) can be handled simultaneously.

7. The method for handling components (3) according to claim 6, wherein
- the components (3) are provided at pick-up positions (10) on the placement machine (1),
- the distance (d) of the holding means (23) is adjusted in such a manner that a plurality of components (3) can be picked up simultaneously from their pick-up positions (10) by the holding means (23).

8. The method for handling components (3) according to any one of the claims 6 and 7, wherein
- a placement position (11) is clearly assigned to each component (3) on the substrate (2),
- the distance (d) of the holding means (23) is adjusted in such a manner that a plurality of components (3) held by the holding means (23) can be placed simultaneously onto the substrate (2).

9. The method for handling components (3) according to claim 8, wherein
after adjusting the distance (d) of the holding means (23) and prior to placing the components (3) onto the substrate (2), the placement head (6) is moved to a checking device (31) for checking the position of the picked-up components (3).

10. The method for handling components (3) according to claim 8, wherein
- prior to placing the components (3) onto the substrate (2), the placement head (6) is moved to a checking device (31) for checking the position of the picked-up components (3),
- prior to the checking process, the handling devices (22) are rotated about their swivel axes (S) in such a manner that the relative distance (d) of the picked-up components (3) is reduced.

## Revendications

1. Automate de placement (1) destiné à équiper des substrats (2) en composants (3), avec:
- une tête de placement (6), aven :
• un corps de base (21) qui est monté pivotable autour d'un axe de rotation (D) dirigé vers un plan de substrat (E),
• au moins deux systèmes de manutention (22) qui sont disposés sur le corps de base (21) et comportent respectivement des moyens de retenue (23) pour fixer les composants (3),
- un dispositif de positionnement (7, 8), au moyen duquel la tête de placement peut être mobile parallèlement au plan de substrat (E),
pour lequel au moins un des systèmes de manutention (22) comporte un axe de pivotement (S) de sorte que par la rotation autour de cet axe de pivotement (S), l'intervalle relatif (d) des moyens de retenue (23) peut être modifié lors du dépôt des composants (3), **caractérisé en ce que** l'intervalle relatif peut être modifié lors du dépôt simultané des composants.

2. Automate de placement (1) selon la revendication 1,
pour lequel le au moins un axe de pivotement (S) est disposé parallèlement à l'axe de rotation (D).

3. Automate de placement (1) selon l'une quelconque des revendications 1 ou 2,
pour lequel les au moins deux systèmes de manutention (22) comportent des commandes de pivotement individuelles (24) au moyen desquelles le système de manutention (22) respectif peut tourner autour de son axe de pivotement (S) respectif.

4. Automate de placement (1) selon l'une quelconque des revendications 1 à 3,
pour lequel les au moins deux systèmes de manutention (22) comportent d'autres commandes individuelles (25) au moyen desquelles les moyens de retenue (23) peuvent tourner respectivement autour d'un axe z, parallèlement à l'axe de rotation (D), ainsi qu'être mobiles en direction de cet axe z respectif.

5. Automate de placement (1) selon l'une quelconque des revendications 1 à 4,
pour lequel le corps de base (21) est réalisé en symétrie de rotation par rapport à l'axe de rotation (D) et les systèmes de manutention (22) sont disposés dans les zones de bordure du corps de base (21).

6. Procédé pour la manipulation des composants (3) pour un automate de placement (1) selon la revendication 1, pour lequel
l'intervalle (d) des moyens de retenue (23) est réglé par rotation des systèmes de manutention (22) autour de l'axe de pivotement (S) respectif de telle sorte que plusieurs composants (3) peuvent être manipulés simultanément.

7. Procédé pour la manipulation de composants (3) selon la revendication 6, pour lequel
- les composants (3) sont préparés dans des positions d'enlèvement (10) sur les automates de placement (1),
- l' intervalle (d) des moyens de reteneue (23) est réglé de telle sorte que plusieurs composants (3) peuvent être simultanément prélevés de leurs positions d'enlèvement (10) par les moyens de retenue (23).

8. Procédé pour la manipulation des composants (3) selon l'une quelconque des revendications 6 et 7, pour lequel
- à chaque composant (3) est clairement attribué une position de placement (11) sur le substrat (2),
- l' intervalle (d) des moyens des retenue (23) est réglé de telle sorte que plusieurs composants (3) maintenus par les moyens de retenue (23) peuvent être déposés simultanément sur le substrat (2).

9. Procédé pour la manipulation des composants (3) selon la revendication 8, pour lequel
après le réglage de l'intervalle (d) des moyens de retenue (23) et avant le dépôt des composants (3) sur le substrat (2), la tête de placement (6) est déplacée vers un dispositif de contrôle (31) pour vérifier la position des composants (3) prélevés.

10. Procédé pour la manipulation des composants (3) selon la revendication 8, pour lequel
- avant le dépôt des composants (3) sur le substrat (2), la tête de placement (6) est déplacée vers un dispositif de contrôle (31) pour vérifier la position des composants prélevés (3),
- avant l'opération de contrôle, les systèmes de manutention (22) sont tournés autour de leur axe de pivotement (S) de telle sorte que l'intervalle (d) relatif des composants (3) prélevés est réduit.
